# EUROPÄISCHE PATENTANMELDUNG

(11) **EP 3 339 839 A1**
(43) Veröffentlichungstag der Anmeldung: **27.06.2018**
(21) Anmeldenummer: 17150724.7
(22) Anmeldetag: 09.01.2017
(51) Int. Cl.: G01N 21/3504, G01N 21/27, G01N 21/39, H01S 5/062, G01J 3/433, H01S 5/06, H01S 5/00, G01J 3/02

(54) **VERFAHREN ZUR KORREKTUR DER WELLENLÄNGE UND DES ABSTIMMBEREICHS EINES LASERSPEKTROMETERS**

(30) Priorität: 23.12.2016 DE 102016226215
(71) Anmelder: Siemens Aktiengesellschaft, 80333 München (DE)
(72) Erfinder: Depenheuer, Daniel, 67365 Schwegenheim (DE)

(57) **Zusammenfassung**

Bei einem Laserspektrometer wird das Licht einer wellenlängendurchstimmbaren Laserdiode (3) nach Durchstrahlen eines Gases (1, 18) detektiert und ausgewertet, wobei die Laserdiode (3) mit einer Stromrampe (9) periodisch angesteuert wird, so dass bei der Detektion des Lichts (4) ein zeitaufgelöstes Absorptionsspektrum des Gases (1, 18) erhalten wird.

Zur Korrektur der Wellenlänge und des Abstimmbereichs des Laserspektrometers wird in einem ersten Schritt die Zentralwellenlänge der Laserdiode (3) über deren Temperatur und anhand der Position einer von zwei unterschiedlichen ausgewählten Absorptionslinien in dem detektierten Absorptionsspektrum nachjustiert und in einem zweiten Schritt der Abstimmbereich der Laserdiode (3) über die Steigung der Stromrampe (11) so korrigiert, dass der Abstand der beiden Absorptionslinien in dem detektierten Absorptionsspektrum gleich bleibt.

## Beschreibung

Die Erfindung betrifft ein Verfahren zur Korrektur der Wellenlänge und des Abstimmbereichs eines Laserspektrometers, bei dem das Licht einer wellenlängendurchstimmbaren Laserdiode nach Durchstrahlen eines Gases detektiert und ausgewertet wird, wobei die Laserdiode mit einer Stromrampe periodisch angesteuert wird, so dass bei der Detektion des Lichts ein zeitaufgelöstes Absorptionsspektrum des Gases erhalten wird, wobei
- in dem aktuell erhaltenen Absorptionsspektrum die Istposition einer Absorptionslinie des Gases mit der bei einer vorangegangenen einmaligen Justierung des Laserspektrometers detektierten und abgespeicherten Sollposition derselben Absorptionslinie verglichen wird und
- in einem Korrekturschritt bei einer Abweichung der Istposition der Absorptionslinie von der Sollposition die Temperatur der Laserdiode verändert wird, bis die Istposition der Sollposition entspricht.

Ein derartiges Verfahren ist aus der DE 10 2011 080 086 A1 oder DE 10 2013 201 459 A1 bekannt.

In der Laserabsorptionsspektroskopie wird ein Messgasgemisch mit dem Licht einer wellenlängendurchstimmbaren Laserdiode durchstrahlt und die Konzentration einer interessierenden Gaskomponente des Messgasgemischs anhand der durch die Absorption des Lichts an der Stelle einer ausgewählten Absorptionslinie der Gaskomponente hervorgerufenen Minderung der Lichtintensität bestimmt. Dabei wird die Laserdiode periodisch mit einer dreieck- oder sägezahnförmigen Strom-Zeit-Funktion (Stromrampe) angesteuert, um die Absorptionslinie der Gaskomponente wellenlängenabhängig abzutasten. Zur Erhöhung der Messgenauigkeit kann die Strom-Zeit-Funktion mit einem sinusförmigen Signal vorgegebener Frequenz f und Amplitude moduliert und das Licht bei einer höheren Harmonischen der Frequenz, üblicherweise der doppelten Frequenz 2f, phasensensitiv detektiert und ausgewertet werden (sog. Wellenlängenmodulationsspektroskopie oder WMS). Der 2f-Signalanteil in dem detektierten Licht bzw. dem erhaltenen Detektionssignal ist von dem Modulationsverhältnis, d. h. von dem Verhältnis der Modulationsamplitude zur Breite der abgetasteten Absorptionslinie, abhängig und ist bei einem Modulationsverhältnis von 2,2 maximal. (DE 10 2011 083 750 A1)

Neben dem Injektionsstrom bestimmt auch die Temperatur der Laserdiode in starkem Maße die Intensität und Wellenlänge des erzeugten Lichts, weswegen die Laserdiode auf einer Wärmesenke montiert wird, deren Temperatur geregelt wird. Aufgrund von Alterung der Laserdiode sinkt die optische Leistung und ändert sich die Wellenlänge des erzeugten Lichts, so dass Maßnahmen zur Wellenlängenstabilisierung erforderlich sind. Dazu wird, wie aus der oben genannten DE 10 2011 080 086 A1 oder DE 10 2013 201 459 A1 bekannt, neben der Absorptionslinie der zu messenden Gaskomponente auch eine Absorptionslinie eines Referenzgases oder -gasgemischs abgetastet, welches zusammen mit dem Messgas in demselben Lichtweg liegt und so gleichzeitig mit diesem durchstrahlt wird. Die Temperatur der Laserdiode bzw. der Wärmesenke wird dann über die Position der Absorptionslinie des Referenzgases in dem detektierten Absorptionsspektrum derart geregelt, dass sich diese Referenz-Absorptionslinie immer an derselben Stelle befindet. Damit liegt in erster Näherung auch die Absorptionslinie der interessierenden Gaskomponente immer an derselben Stelle der sie abtastenden Strom-Zeit-Funktion.

Aus der US 5,459,574 A ist es bekannt, einen Teil des von der Laserdiode kommenden Lichts mittels eines Strahlteilers aus dem Lichtweg zu dem Messgasgemisch auszukoppeln und nach Durchstrahlen des Referenzgases separat zu detektieren.

Aus der DE 10 2011 080 086 A1 oder DE 10 2013 201 459 A1 ist es ferner bekannt, die Laserdiode am Anfang und am Ende der Stromrampe mit unterschiedlichen Strombursts anzusteuern und anhand der unterschiedlichen Stromstärken der Strombursts und der an den Positionen der Strombursts detektierten Lichtintensitäten durch Interpolation einen Lichtintensitätswert für die Stromrampe an der Position der interessierenden Absorptionslinie zu berechnen mit dem die dort detektierte Lichtintensität normiert wird. Die Genauigkeit der Interpolation, die bei zwei unterschiedlichen Strombursts einfach linear erfolgt, kann dadurch erhöht werden, dass die Laserdiode regelmäßig mit einem zusätzlichen Stromburst angesteuert wird, dessen Stromstärke von denen der anderen Strombursts verschieden ist, und dass der Lichtintensitätswert für die Stromrampe an der Position der interessierenden Absorptionslinie anhand der Stromstärken aller Strombursts und der an den Positionen der Strombursts detektierten Lichtintensitäten durch Polynominterpolation berechnet wird.

Wie in DE 10 2011 083 750 A1 erläutert wird, müssen Laserspektrometer erstmalig bei ihrer Herstellung in Bezug auf die Wellenlänge und den Abstimmbereich eingestellt bzw. justiert werden. Die Feineinstellung der Wellenlänge kann, wie oben bereits erläutert, unter Zuhilfenahme einer Referenz-Absorptionslinie erfolgen, weil deren Wellenlängenposition mit einer höheren Genauigkeit bestimmt ist, als z. B. die Genauigkeit eines Wavemeters. Zu diesem Zweck wird eine mit einem Referenzgas gefüllte Küvette (Gaszelle) in den Lichtweg des Laserspektrometers gebracht. Der Abstimmbereich, d. h. die Wellenlängenänderung bei vorgegebener Strom-Zeit-Funktion (Stromrampe), kann unter Zuhilfenahme eines Etalons festgelegt werden, der ebenfalls in den Lichtweg des Laserspektrometers gebracht wird.

Während die mit dem Referenzgas bzw. Referenzgasgemisch gefüllte Küvette in dem Laserspektrometer verbleiben kann, um, wie oben erläutert, im laufenden Messbetrieb die Position der Referenz-Absorptionslinie in dem detektierten Absorptionsspektrum über die Temperatur der Laserdiode nachzuregeln, ist eine Nachjustierung des Abstimmbereichs im laufenden Messbetrieb unter Verwendung eines Etalons nicht möglich. Die bereits erwähnte Annahme, dass bei Konstanthaltung der Position der Referenz-Absorptionslinie in dem detektierten Absorptionsspektrum auch die Position der Absorptionslinie der zu messenden Gaskomponente konstant bleibt, trifft nur in erster Näherung zu, weil sich bei Alterung der Laserdiode nicht nur ihre Zentralwellenlänge sondern auch ihr Abstimmverhalten über den Strom verändert. So kann sich beispielsweise bei Ansteuerung der Laserdiode mit einer Stromrampe von 30 mA (peak-to-peak) die erzielte Wellenlängenänderung altersbedingt von ursprünglich 40 GHz nach 42 GHz verschieben. Bei Auswertung der interessierenden Absorptionslinie der zu messenden Gaskomponente auf Basis ihrer Fläche würde dies zu einer Änderung des Messergebnisses von etwa 5% führen. Es ist auch möglich, dass aufgrund der veränderten Breite der Absorptionslinie der Auswertealgorithmus nicht mehr zuverlässig funktioniert, wenn z. B. die Auswertung auf einer Multivariantenanalyse basiert, bei der das gemessene Absorptionsspektrum mit vorab aufgenommenen oder berechneten Spektren verglichen wird. Das Problem wird verstärkt, wenn die Laserdiode über einen sehr großen Bereich durchgestimmt wird, so dass die Änderung des Injektionsstroms und die der Wellenlänge nicht mehr proportional zueinander sind. Derart große Abstimmbereiche mit einem nennenswerten nichtlinearen Anteil in der Abstimmungsrate kommen in der Praxis regelmäßig vor. Auch können solche Nichtlinearitäten exemplarabhängig sein, weil sich jede einzelne Laserdiode anders verhält.

Bisher wird daher üblicherweise eine regelmäßige Verifikation der Messungen des Laserspektrometers durchgeführt. Entsprechen die Messergebnisse bei der Verifikation nicht mehr den Erwartungen, so wird das Gerät neu- oder nachkalibriert. Je nach Gerät kann dies vom Kunden, vom Service oder nur im Werk durchgeführt werden.

Der Erfindung liegt daher die Aufgabe zugrunde, eine Korrektur der Wellenlänge und des Abstimmbereichs eines Laserspektrometers zu ermöglichen, ohne dies aus dem laufenden Messbetrieb bzw. der Messanordnung herausnehmen zu müssen. Dies gilt insbesondere für In-situ-Messungen, wenn z. B. die Laserdiode und der Detektor in an gegenüberliegenden Stellen einer Prozessgasleitung, eines Abgaskanals usw. montierten Messköpfen untergebracht sind.

Gemäß der Erfindung wird die Aufgabe dadurch gelöst, dass bei dem Verfahren der eingangs angegebenen Art,
- in dem aktuell erhaltenen Absorptionsspektrum die Istposition einer weiteren Absorptionslinie mit der bei einer vorangegangenen einmaligen Justierung des Laserspektrometers detektierten und abgespeicherten Sollposition derselben Absorptionslinie verglichen wird und
- in einem weiteren Korrekturschritt bei einer Abweichung der Istposition der weiteren Absorptionslinie von ihrer Sollposition die Steigung der Stromrampe verändert wird, bis die Istposition der Sollposition entspricht.

Unter der einmaligen Justierung des Laserspektrometers ist neben der erstmaligen werksseitigen Einstellung seiner Wellenlänge und seines Abstimmbereichs auch jede Neu- oder Nachkalibration zu verstehen, die vom Kunden, vom Service oder im Werk durchgeführt wird.

Das erfindungsgemäße Verfahren sieht also vor, in einem ersten Schritt die Zentralwellenlänge der Laserdiode über deren Temperatur und anhand der Position einer von zwei unterschiedlichen ausgewählten, d. h. eindeutig detektierbaren, Absorptionslinien in dem detektierten Absorptionsspektrum nachzujustieren und in einem zweiten Schritt den Abstimmbereich der Laserdiode über die Steigung der Stromrampe so zu korrigieren, dass der Abstand der beiden Absorptionslinien in dem detektierten Absorptionsspektrum gleich bleibt. Da die absoluten Wellenlängen der beiden Absorptionslinien bekannt sind, kann der Abstimmbereich der Laserdiode, d. h. die Wellenlängenänderung bei linearer Strom-Zeit-Funktion (Stromrampe), unmittelbar berechnet werden. Die Korrektur der Wellenlänge und des Abstimmbereichs ist umso genauer und zuverlässiger, je größer der Abstand zwischen den beiden Absorptionslinien ist. Daher werden die beiden Absorptionslinien vorzugsweise so gewählt, dass eine von ihnen möglichst nahe am Anfang und die andere möglichst nahe am Ende des Abstimmbereichs liegt, während z. B. die Absorptionslinie der zu messenden Gaskomponente vorzugsweise in der Mitte des Abstimmbereichs liegt.

Durch die Korrektur des Abstimmbereichs der Laserdiode über die Steigung der Stromrampe kann die zuvor über die Temperatur der Laserdiode korrigierte Zentralwellenlänge wieder verändert werden, so dass beide Korrekturschritte vorzugsweise wiederholt nacheinander ausgeführt werden. Die Rekursion kann gestartet und solange durchgeführt werden, wenn bzw. wie die Abweichungen zwischen den Soll- und Istpositionen vorgegebenen Schwellenwerte überschreiten.

Grundsätzlich könnte die Korrektur der Zentralwellenlänge der Laserdiode anstatt über deren Temperatur dadurch erfolgen, dass ein Strom-Offset auf die Stromrampe addiert wird. Allerdings ändern sich die Abstimmeigenschaften von Laserdioden typischerweise sehr viel stärker bei Änderungen des absoluten Niveaus des Stroms, als bei einer Änderung der Lasertemperatur. Weiterhin müsste man bei vielen Laserdioden eine relativ große Änderung des Stromniveaus verwenden, wohin gegen eine vergleichsweise kleine Temperaturänderung ausreicht. Daher ist für die Korrektur der Zentralwellenlänge in nahezu allen Fällen eine Änderung der Lasertemperatur einer Änderung des Laserstroms vorzuziehen.

Für den Fall, dass die Laserdiode ein nichtlineares Abstimmverhalten aufweist, kann entsprechend einer vorteilhaften Weiterbildung des erfindungsgemäßen Verfahrens die Stromrampe aus einer Strom-Zeit-Funktion mit einem linearen und mindestens einem nichtlinearen Term gebildet werden. Der lineare Funktionsterm entspricht dabei der Steigung der Stromrampe, während der mindestens eine nichtlineare Term einen nichtlinearen Verlauf der Steigung bezeichnet. Beim Durchstimmen der Laserdiode wird dann die Position mindestens einer zwischen den beiden Absorptionslinien liegenden zusätzlichen Absorptionslinie detektiert. Bei einer Abweichung zwischen der aktuell detektierte Istposition dieser zusätzlichen Absorptionslinie und der bei der vorangegangenen einmaligen Justierung des Laserspektrometers detektierten und abgespeicherten Sollposition derselben Absorptionslinie wird in einem zusätzlichen Korrekturschritt der mindestens eine nichtlineare Term verändert wird, bis die Istposition der Sollposition entspricht. Bei dem mindestens einen nichtlinearen Funktionsterm kann es sich im einfachsten Fall um einen quadratischen oder kubischen Term handeln, wobei insbesondere bei sehr großen Abstimmbereichen auch komplexere Terme erforderlich sein können, die das Abstimmverhalten der Laserdiode besser beschreiben. Auch hier kann es nach jedem Ändern des/der nichtlinearen Terms/Terme notwendig sein, die zuvor korrigierten Positionen der anderen Referenz-Absorptionslinien durch Anpassung der Lasertemperatur und des Abstimmbereichs des Stroms nachzukorrigieren.

Die genannten Korrekturschritte werden von dem Laserspektrometer automatisch durchgeführt. Danach stimmt die Laserdiode wieder genau den gleichen Wellenlängenbereich ab, wie sie es bei der Kalibration getan hat. Änderungen des Abstimmverhaltens durch Laseralterung wurden also kompensiert.

Weil die Laseralterung ein sehr langsamer Prozess ist und durch äußere Störeinflüsse und Rauschen überlagert ist, werden die Korrekturschritte in der Praxis nur selten oder nur dann durchgeführt, wenn eine Positionsänderung der betrachten Absorptionslinien gegenüber der Kalibration festgestellt wird, oder es werden nur sehr lange gemittelte Spektren für die Korrektur verwendet. Wie bereits erwähnt, kann die Korrektur der Wellenlänge und des Abstimmbereichs im laufenden Messbetrieb des Laserspektrometers erfolgen, was aber nicht notwendigerweise bedeutet, dass während der Korrektur die interessierende Gaskomponente gemessen wird. Entscheidend bei dem erfindungsgemäßen Verfahren ist, dass die Korrektur automatisch erfolgt und das Laserspektrometer dafür nicht aus dem Messbetrieb oder der Messanordnung herausgenommen werden muss.

Sind die Umgebungsbedingungen (Druck, Temperatur) bei der einmaligen Justierung, z. B. Kalibration, des Laserspektrometers und zum Zeitpunkt der Korrektur seiner Wellenlänge und seines Abstimmbereichs gleich, so können in vorteilhafter Weise ausgewählte Absorptionslinien des Messgasgemischs, ggf. auch die Absorptionslinie der zu messenden Gaskomponente, für die Korrektur verwendet werden. Sobald daher in dem Absorptionsspektrum des Messgasgemischs zwei oder mehr Absorptionslinien sicher gemessen werden können, kann das erfindungsgemäße Verfahren angewendet werden. Dazu ist bei einem vorhandenen Laserspektrometer im Wesentlichen nur eine Funktionserweiterung in der Software erforderlich ist.

Um von den genannten Umgebungsbedingungen unabhängig zu sein, können alternativ, ggf. zusätzlich, Absorptionslinien eines Referenzgases oder -gasgemischs verwendet werden, wobei das in einer Küvette enthaltene Referenzgas und das Messgasgemisch in demselben Lichtweg liegend nacheinander durchstrahlt werden können. Dabei können die Absorptionslinien des Referenzgases mit demselben Detektor detektiert werden, mit dem auch die Absorptionslinie der in dem Messgasgemisch zu messenden Gaskomponente detektiert wird. Alternativ kann bei Anordnung der Küvette mit dem Referenzgas vor dem Messgasgemisch ein Teil des aus dem Referenzgas austretenden Lichts mittels eines Strahlteilers aus dem Lichtweg zu dem Messgasgemisch ausgekoppelt und mit einem weiteren Detektor separat detektiert werden. In diesem Fall ist das separat detektierte Absorptionsspektrum des Referenzgases nicht von dem des Messgasgemischs überlagert. Das detektierte Absorptionsspektrum des Messgasgemischs ist zwar von dem des Referenzgases überlagert, jedoch kann das separat detektierte Absorptionsspektrum des Referenzgases davon subtrahiert werden, so dass auch das Absorptionsspektrum des Messgasgemischs überlagerungsfrei erhalten wird. Alternativ kann die Küvette mit dem Referenzgas zwischen dem Strahlteiler und dem weiteren Detektor angeordnet werden, so dass das detektierte Absorptionsspektrum des Messgasgemischs nicht von dem des Referenzgases überlagert wird.

Das erfindungsgemäße Korrekturverfahren ist sowohl im Falle der direkten Absorptionsspektroskopie als auch im Falle der Wellenlängenmodulationsspektroskopie anwendbar. Während bei der direkten Absorptionsspektroskopie die Konzentration der interessierenden Gaskomponente unmittelbar aus der an der Stelle der Absorptionslinie detektierten Minderung der Lichtintensität (Absorption) bestimmt wird, wird bei der Wellenlängenmodulationsspektroskopie während der vergleichsweise langsamen wellenlängenabhängigen Abtastung der Absorptionslinie zusätzlich die Wellenlänge des erzeugten Lichts mit hoher Frequenz und kleiner Amplitude sinusförmig moduliert. Das Licht wird dann bei einer höheren Harmonischen der Frequenz phasensensitiv detektiert. Entsprechend einer vorteilhaften Weiterbildung des erfindungsgemäßen Verfahrens wird im Falle der Wellenlängenmodulationsspektroskopie proportional mit der Änderung der Steigung oder des nichtlinearen Terms der Stromrampe auch die Amplitude der Wellenlängenmodulation verändert. Alternativ kann nach Änderung der Steigung oder des nichtlinearen Terms der Stromrampe anhand einer der phasensensitiv detektierten Absorptionslinien eine Veränderung des Modulationsverhältnisses ermittelt und in Abhängigkeit davon die Modulationsamplitude korrigiert werden.

Gegenstand der Erfindung ist auch ein Laserspektrometer zur Durchführung des erfindungsgemäßen Verfahrens.

Zur weiteren Erläuterung der Erfindung wird im Folgenden auf die Figuren der Zeichnung Bezug genommen; im Einzelnen zeigen
- Figur 1: eine schematische Darstellung eines Laserspektrometers zur Durchführung des erfindungsgemäßen Verfahrens, die
- Figuren 2 bis 4: weitere Ausführungsbeispiele für das Laserspektrometer und die
- Figuren 5 bis 9: ein Beispiel für die Auswirkung der erfindungsgemäßen Korrektur der Wellenlänge und des Abstimmbereichs des Laserspektrometers auf das detektierte Absorptionsspektrum.

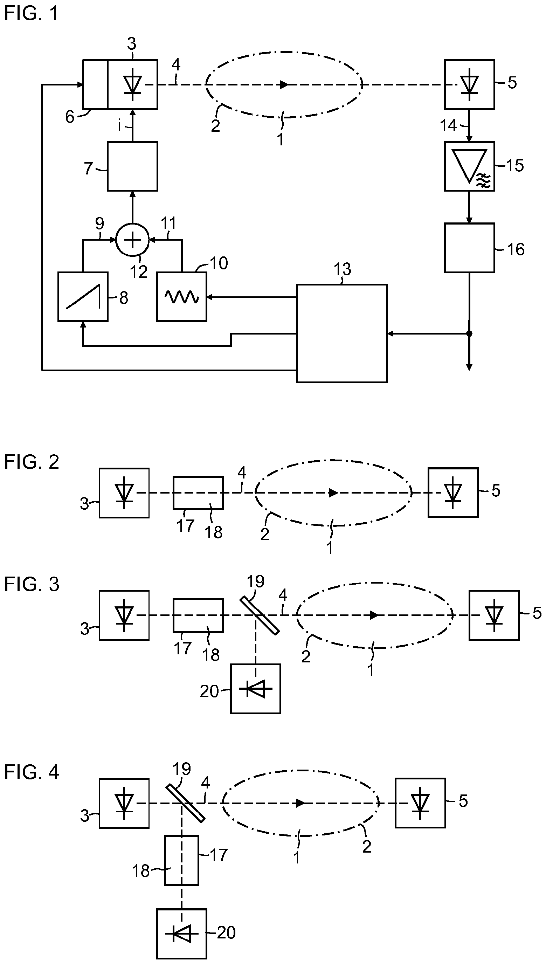

Figur 1 zeigt beispielhaft ein Laserspektrometer zur Messung der Konzentration mindestens einer interessierenden Gaskomponente eines Messgasgemischs 1, das in einem Messvolumen 2, beispielsweise einer Messküvette oder einer Prozessgasleitung, enthalten ist. Das Spektrometer enthält eine Laserdiode 3, deren Licht 4 durch das Messgas 1 auf einen Detektor 5 fällt. Die Laserdiode 3 ist auf einer temperaturgeregelten Wärmesenke 6 montiert und wird von einer steuerbaren Stromquelle 7 mit einem Injektionsstrom i angesteuert. Die Intensität und Wellenlänge des erzeugten Lichts 4 sind von dem Injektionsstrom i und der Betriebstemperatur der Laserdiode 3 abhängig. Die Stromquelle 6 wird von einem ersten Signalgenerator 7 periodisch mit einer rampenförmigen Strom-Zeit-Funktion (Stromrampe) 9 angesteuert, um mit dem entsprechend modulierten Licht 4 eine ausgewählte Absorptionslinie einer interessierenden Gaskomponente des Messgasgemischs 1 abzutasten. Die Strom-Zeit-Funktion 9 kann neben einem die Steigung der Stromrampe angebenden linearen Funktionsterm (Parameter) einen oder weitere Funktionsterme aufweisen, die eine nichtlineare Verformung der Stromrampe bewirken. Ein zweiter Signalgenerator 10 erzeugt ein sinusförmiges Signal (Modulationssignal) 11 der Frequenz f, mit dem in einem Summierglied 12 die Stromrampe 9 moduliert wird.

Die Betriebstemperatur der Laserdiode 3, die Funktionsterme der Stromrampe 9 und die Amplitude des Modulationssignals 2 können mittels einer Steuereinrichtung 13 eingestellt werden.

Der Detektor 5 erzeugt in Abhängigkeit von der detektierten Lichtintensität ein Detektorsignal 14, das als Information ein zeitaufgelöstes Absorptionsspektrum des Messgasgemischs 1 enthält. Das Detektorsignal 14 wird in einem frequenzselektiven Verstärker 15 bei der n-ten, vorzugsweise zweiten, Harmonischen der Modulationsfrequenz f verstärkt und in einer nachfolgenden Auswerteeinrichtung 16 phasensensitiv (lock-in) weiterverarbeitet und zu einem Messwert für die Konzentration der interessierenden Gaskomponente des Messgasgemischs ausgewertet.

Die Figuren 2, 3 und 4 zeigen anhand eines Ausschnitts aus Figur 1 unterschiedliche Varianten des Laserspektrometers, bei denen gleichzeitig mit dem Messgasgemisch 1 ein in einer Küvette 17 enthaltenes Referenzgas oder Referenzgasgemisch 18 mit dem Licht 4 der Laserdiode 3 durchstrahlt wird. In den Beispielen der Figuren 2 und 3 liegen die Küvette 17 und das Messvolumen 2 hintereinander in demselben Lichtweg, so dass der Detektor 5 über den Abstimmbereich der Laserdiode 3 sowohl das Absorptionsspektrum des Messgasgemischs 1 als auch das des Referenzgases oder Referenzgasgemischs 18 detektiert. Bei dem Beispiel nach Figur 3 wird ein Teil des aus der Küvette 17 austretenden Lichts 4 mittels eines Strahlteilers 19 aus dem Lichtweg zu dem Messvolumen 2 ausgekoppelt und auf einen weiteren Detektor 20 geführt, der auf diese Weise das Absorptionsspektrum des Referenzgases oder Referenzgasgemischs 18 separat detektiert. Zur Ermittlung der Konzentration der interessierenden Gaskomponente des Messgasgemischs 1 durch die Auswerteeinrichtung 16 kann zuvor, z. B. unmittelbar hinter dem Detektor 5, das separat detektierte Absorptionsspektrum des Referenzgases oder Referenzgasgemischs 18 von dem des Messgasgemischs 1 subtrahiert werden. In dem Beispiel nach Figur 4 ist schließlich die Küvette 17 im Lichtweg zwischen dem Strahlteiler 19 und dem weiteren Detektor 20 angeordnet, so dass das von dem Detektor 5 detektierte Absorptionsspektrum des Messgasgemischs 1 nicht von dem des Referenzgases oder Referenzgasgemischs 18 überlagert ist.

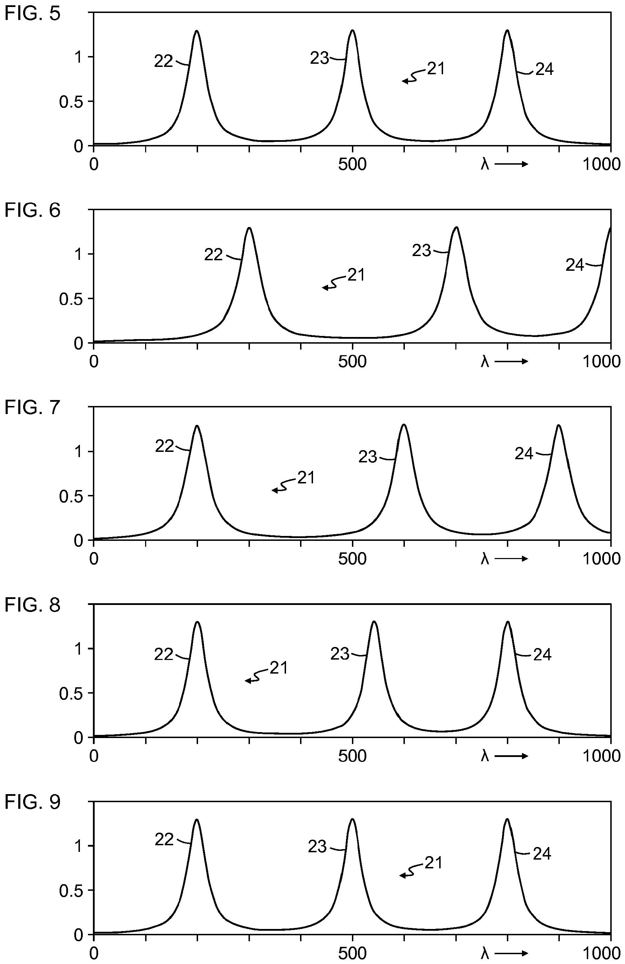

Die Figuren 5 bis 9 zeigen beispielhaft die Auswirkung der erfindungsgemäßen Korrektur der Wellenlänge und des Abstimmbereichs des Laserspektrometers auf das detektierte Absorptionsspektrum 21 über den Wellenlängen-Abstimmbereich der Laserdiode 3, der hier auf einen Bereich von 0 bis 1000 normiert ist. Bei dem Absorptionsspektrum 21 kann es sich um das des Messgasgemischs 1 und/oder das des Referenzgases 18 handeln, wobei hier nur die bei dem erfindungsgemäßen Verfahren betrachteten Absorptionslinien 22, 23 und 24 gezeigt sind. Figur 5 zeigt das nach einer Kalibration des Laserspektrometers erhaltene Absorptionsspektrum 21 mit den Sollpositionen der Absorptionslinien 22, 23 und 24.

Figur 6 zeigt dasselbe Absorptionsspektrum 21 nach längerem Gebrauch des Laserspektrometers, wobei sich die Positionen der Absorptionslinien 22, 23 und 24 zu den aktuellen Istpositionen hin verschoben haben.

Figur 7 zeigt, wie anhand der Absorptionslinie 22 durch Änderung der Temperatur der Laserdiode 3 die Istposition dieser Absorptionslinie 22 auf die Sollposition zurückgeschoben wird. Da sich bei Alterung der Laserdiode 3 nicht nur ihre Zentralwellenlänge sondern auch ihr Abstimmverhalten über den Strom verändert hat, weichen die Istpositionen der übrigen Absorptionslinien 23 und 24 nach wie vor von den Sollpositionen ab.

Figur 8 zeigt, wie anhand der Absorptionslinie 24 durch Änderung der Steigung der Stromrampe 9 (linearer Term der Strom-Zeit-Funktion) die Istposition dieser Absorptionslinie 24 auf ihre Sollposition zurückgeschoben wird. Da das Abstimmverhalten der Laserdiode 3 nichtlinear ist, weicht die Istposition der mittleren Absorptionslinie 23 immer noch von ihrer Sollposition ab.

Figur 9 zeigt schließlich, wie anhand der Absorptionslinie 23 durch Änderung des nichtlinearen Terms der Stromrampe 9 auch die Istposition dieser Absorptionslinie 24 auf ihre Sollposition zurückgeschoben wird. Im Ergebnis entsprich das in Figur 5 gezeigte korrigierte Absorptionsspektrum 21 dem nach Figur 1.

Die im Zusammenhang mit den Figuren 7 bis 9 erläuterten Korrekturschritte müssen ggf. mehrfach hintereinander ausgeführt werden.

## Patentansprüche

1. Verfahren zur Korrektur der Wellenlänge und des Abstimmbereichs eines Laserspektrometers, bei dem das Licht einer wellenlängendurchstimmbaren Laserdiode (3) nach Durchstrahlen eines Gases (1, 18) detektiert und ausgewertet wird, wobei die Laserdiode (3) mit einer Stromrampe (9) periodisch angesteuert wird, so dass bei der Detektion des Lichts (4) ein zeitaufgelöstes Absorptionsspektrum des Gases (1, 18) erhalten wird, wobei
- in dem aktuell erhaltenen Absorptionsspektrum die Istposition einer Absorptionslinie (22) des Gases (1, 18) mit der bei einer vorangegangenen einmaligen Justierung des Laserspektrometers detektierten und abgespeicherten Sollposition derselben Absorptionslinie (22) verglichen wird und
- in einem Korrekturschritt bei einer Abweichung der Istposition der Absorptionslinie (22) von der Sollposition die Temperatur der Laserdiode (3) verändert wird, bis die Istposition der Sollposition entspricht,
**dadurch gekennzeichnet**,
- in dem aktuell erhaltenen Absorptionsspektrum die Istposition einer weiteren Absorptionslinie (24) mit der bei einer vorangegangenen einmaligen Justierung des Laserspektrometers detektierten und abgespeicherten Sollposition derselben Absorptionslinie (24) verglichen wird und
- in einem weiteren Korrekturschritt bei einer Abweichung der Istposition der weiteren Absorptionslinie (24) von ihrer Sollposition die Steigung der Stromrampe (9) verändert wird, bis die Istposition der Sollposition entspricht.

2. Verfahren nach Anspruch 1, **dadurch gekennzeichnet, dass** der Korrekturschritt und der weitere Korrekturschritt wiederholt nacheinander ausgeführt werden.

3. Verfahren nach Anspruch 1, **dadurch gekennzeichnet, dass** der Korrekturschritt und der weitere Korrekturschritt in Abhängigkeit davon ausgeführt werden, dass die jeweilige Abweichung zwischen Soll- und Istposition einen vorgegebenen Schwellenwert überschreitet.

4. Verfahren nach einem der vorangehenden Ansprüche, **dadurch gekennzeichnet, dass**
dass die Stromrampe (9) aus einer Strom-Zeit-Funktion mit einem linearen und mindestens einem nichtlinearen Term gebildet wird,
dass in dem aktuell erhaltenen Absorptionsspektrum die Istposition mindestens einer zwischen der einen und der weiteren Absorptionslinie (22,24) liegenden zusätzlichen Absorptionslinie (23) mit der bei der vorangegangenen einmaligen Justierung des Laserspektrometers detektierten und abgespeicherten Sollposition derselben Absorptionslinie (23) verglichen wird, und
dass in einem auf den weiteren Korrekturschritt folgenden zusätzlichen Korrekturschritt bei einer Abweichung der Istposition der mindestens einen zusätzlichen Absorptionslinie (23) von ihrer Sollposition der mindestens eine nichtlineare Term verändert wird, bis die Istposition der Sollposition entspricht.

5. Verfahren nach einem der vorangehenden Ansprüche, **dadurch gekennzeichnet, dass** es sich bei zumindest einer der für die Korrektur der Wellenlänge und des Abstimmbereichs des Laserspektrometers verwendeten Absorptionslinien (22, 23, 24) um eine ausgewählte Absorptionslinie einer Gaskomponente eines Messgasgemischs (1) handelt, in dem die Konzentration derselben oder einer anderen interessierenden Gaskomponente des Messgasgemischs (1) durch Auswertung einer Absorptionslinie der betreffenden Gaskomponente bestimmt wird.

6. Verfahren nach einem der vorangehenden Ansprüche, **dadurch gekennzeichnet, dass** es sich bei zumindest einer der für die Korrektur der Wellenlänge und des Abstimmbereichs des Laserspektrometers verwendeten Absorptionslinien (22, 23, 24) um eine ausgewählte Absorptionslinie eines Referenzgases oder Referenzgasgemischs (18) handelt.

7. Verfahren nach Anspruch 6, **dadurch gekennzeichnet, dass** das Referenzgas oder Referenzgasgemisch (18) und ein Messgasgemisch (1) gleichzeitig durchstrahlt werden.

8. Verfahren nach Anspruch 7, **dadurch gekennzeichnet, dass** das Referenzgas oder Referenzgasgemisch (18) und das Messgasgemisch (1) in demselben Lichtweg liegend nacheinander durchstrahlt werden und ein Teil des aus dem Referenzgas oder Referenzgasgemisch (18) austretenden Lichts mittels eines Strahlteilers (19) aus dem Lichtweg zu dem Messgasgemisch (1) ausgekoppelt und separat detektiert wird.

9. Verfahren nach Anspruch 8, **dadurch gekennzeichnet, dass** das separat detektierte Spektrum des Referenzgases oder Referenzgasgemischs (18) von dem des Messgasgemischs (1) subtrahiert wird.

10. Verfahren nach Anspruch 6, **dadurch gekennzeichnet, dass** ein Teil des von der Laserdiode (3) kommenden Lichts (4) mittels eines Strahlteilers (19) aus dem Lichtweg zu dem Messgasgemisch (1) ausgekoppelt und nach Durchstrahlen des Referenzgases oder Referenzgasgemischs (18) separat detektiert wird.

11. Verfahren nach einem der vorangehenden Ansprüche, **dadurch gekennzeichnet, dass** die Stromrampe (9) mit einem sinusförmigen Signal (11) vorgegebener Frequenz und Modulationsamplitude moduliert und das Licht (4) bei einer höheren Harmonischen der Frequenz phasensensitiv detektiert wird und dass proportional mit der Änderung der Steigung oder des nichtlinearen Terms der Stromrampe (9) auch die Modulationsamplitude verändert wird.

12. Verfahren nach einem der Ansprüche 1 bis 10, **dadurch gekennzeichnet, dass** die Stromrampe (9) mit einem sinusförmigen Signal vorgegebener Frequenz und Modulationsamplitude moduliert und das Licht (4) bei einer höheren Harmonischen der Frequenz phasensensitiv detektiert wird und dass nach Änderung der Steigung oder des nichtlinearen Terms der Stromrampe (9) anhand einer der phasensensitiv detektierten Absorptionslinien eine Veränderung des Modulationsverhältnisses ermittelt und in Abhängigkeit davon die die Modulationsamplitude korrigiert wird.

13. Laserspektrometer zur Durchführung des Verfahrens nach einem der vorangehenden Ansprüche.

## Geänderte Patentansprüche

### Geänderte Patentansprüche gemäss Regel 137(2) EPÜ.

1. Verfahren zur Korrektur der Wellenlänge und des Abstimmbereichs eines Laserspektrometers, bei dem das Licht einer wellenlängendurchstimmbaren Laserdiode (3) nach Durchstrahlen eines Gases (1, 18) detektiert und ausgewertet wird, wobei die Laserdiode (3) mit einer Stromrampe (9) periodisch angesteuert wird, so dass bei der Detektion des Lichts (4) ein zeitaufgelöstes Absorptionsspektrum des Gases (1, 18) erhalten wird, wobei
- in dem aktuell erhaltenen Absorptionsspektrum die Istposition einer Absorptionslinie (22) des Gases (1, 18) mit der bei einer vorangegangenen einmaligen Justierung des Laserspektrometers detektierten und abgespeicherten Sollposition derselben Absorptionslinie (22) verglichen wird und
- in einem Korrekturschritt bei einer Abweichung der Istposition der Absorptionslinie (22) von der Sollposition die Temperatur der Laserdiode (3) verändert wird, bis die Istposition der Sollposition entspricht,
**dadurch gekennzeichnet**,
- in dem aktuell erhaltenen Absorptionsspektrum die Istposition einer weiteren Absorptionslinie (24) mit der bei einer vorangegangenen einmaligen Justierung des Laserspektrometers detektierten und abgespeicherten Sollposition derselben Absorptionslinie (24) verglichen wird und
- in einem weiteren Korrekturschritt bei einer Abweichung der Istposition der weiteren Absorptionslinie (24) von ihrer Sollposition die Steigung der Stromrampe (9) verändert wird, bis die Istposition der Sollposition entspricht.

2. Verfahren nach Anspruch 1, **dadurch gekennzeichnet, dass** der Korrekturschritt und der weitere Korrekturschritt wiederholt nacheinander ausgeführt werden.

3. Verfahren nach Anspruch 1, **dadurch gekennzeichnet, dass** der Korrekturschritt und der weitere Korrekturschritt in Abhängigkeit davon ausgeführt werden, dass die jeweilige Abweichung zwischen Soll- und Istposition einen vorgegebenen Schwellenwert überschreitet.

4. Verfahren nach einem der vorangehenden Ansprüche, **dadurch gekennzeichnet, dass**
dass die Stromrampe (9) aus einer Strom-Zeit-Funktion mit einem linearen und mindestens einem nichtlinearen Term gebildet wird,
dass in dem aktuell erhaltenen Absorptionsspektrum die Istposition mindestens einer zwischen der einen und der weiteren Absorptionslinie (22,24) liegenden zusätzlichen Absorptionslinie (23) mit der bei der vorangegangenen einmaligen Justierung des Laserspektrometers detektierten und abgespeicherten Sollposition derselben Absorptionslinie (23) verglichen wird, und
dass in einem auf den weiteren Korrekturschritt folgenden zusätzlichen Korrekturschritt bei einer Abweichung der Istposition der mindestens einen zusätzlichen Absorptionslinie (23) von ihrer Sollposition der mindestens eine nichtlineare Term verändert wird, bis die Istposition der Sollposition entspricht.

5. Verfahren nach einem der vorangehenden Ansprüche, **dadurch gekennzeichnet, dass** es sich bei zumindest einer der für die Korrektur der Wellenlänge und des Abstimmbereichs des Laserspektrometers verwendeten Absorptionslinien (22, 23, 24) um eine ausgewählte Absorptionslinie einer Gaskomponente eines Messgasgemischs (1) handelt, in dem die Konzentration derselben oder einer anderen interessierenden Gaskomponente des Messgasgemischs (1) durch Auswertung einer Absorptionslinie der betreffenden Gaskomponente bestimmt wird.

6. Verfahren nach einem der vorangehenden Ansprüche, **dadurch gekennzeichnet, dass** es sich bei zumindest einer der für die Korrektur der Wellenlänge und des Abstimmbereichs des Laserspektrometers verwendeten Absorptionslinien (22, 23, 24) um eine ausgewählte Absorptionslinie eines Referenzgases oder Referenzgasgemischs (18) handelt.

7. Verfahren nach Anspruch 6, **dadurch gekennzeichnet, dass** das Referenzgas oder Referenzgasgemisch (18) und ein Messgasgemisch (1) gleichzeitig durchstrahlt werden.

8. Verfahren nach Anspruch 7, **dadurch gekennzeichnet, dass** das Referenzgas oder Referenzgasgemisch (18) und das Messgasgemisch (1) in demselben Lichtweg liegend nacheinander durchstrahlt werden und ein Teil des aus dem Referenzgas oder Referenzgasgemisch (18) austretenden Lichts mittels eines Strahlteilers (19) aus dem Lichtweg zu dem Messgasgemisch (1) ausgekoppelt und separat detektiert wird.

9. Verfahren nach Anspruch 8, **dadurch gekennzeichnet, dass** das separat detektierte Spektrum des Referenzgases oder Referenzgasgemischs (18) von dem des Messgasgemischs (1) subtrahiert wird.

10. Verfahren nach Anspruch 6, **dadurch gekennzeichnet, dass** ein Teil des von der Laserdiode (3) kommenden Lichts (4) mittels eines Strahlteilers (19) aus dem Lichtweg zu dem Messgasgemisch (1) ausgekoppelt und nach Durchstrahlen des Referenzgases oder Referenzgasgemischs (18) separat detektiert wird.

11. Verfahren nach einem der vorangehenden Ansprüche, **dadurch gekennzeichnet, dass** die Stromrampe (9) mit einem sinusförmigen Signal (11) vorgegebener Frequenz und Modulationsamplitude moduliert und das Licht (4) bei einer höheren Harmonischen der Frequenz phasensensitiv detektiert wird und dass proportional mit der Änderung der Steigung oder des nichtlinearen Terms der Stromrampe (9) auch die Modulationsamplitude verändert wird.

12. Verfahren nach einem der Ansprüche 1 bis 10, **dadurch gekennzeichnet, dass** die Stromrampe (9) mit einem sinusförmigen Signal vorgegebener Frequenz und Modulationsamplitude moduliert und das Licht (4) bei einer höheren Harmonischen der Frequenz phasensensitiv detektiert wird und dass nach Änderung der Steigung oder des nichtlinearen Terms der Stromrampe (9) anhand einer der phasensensitiv detektierten Absorptionslinien eine Veränderung des Modulationsverhältnisses ermittelt und in Abhängigkeit davon die die Modulationsamplitude korrigiert wird.

13. Laserspektrometer zur Durchführung des Verfahrens nach einem der vorangehenden Ansprüche.
